## Europäisches Patentamt

## European Patent Office

## Office européen des brevets

(11) Numéro de publication: **0 222 656
B1**

(12) **FASCICULE DE BREVET EUROPEEN**

(45) Date de publication du fascicule du brevet:
21.03.90

(51) Int. Cl.⁴: **H05K 9/00**

(21) Numéro de dépôt: 86402364.3

(22) Date de dépôt: 22.10.86

(54) **Joint électrique, élastique entre parois conductrices, orthogonales, indépendantes.**

(30) Priorité: 29.10.85 FR 8516049

(43) Date de publication de la demande:
20.05.87 Bulletin 87/21

(45) Mention de la délivrance du brevet:
21.03.90 Bulletin 90/12

(84) Etats contractants désignés:
DE GB

(56) Documents cités:
DE-B- 1 190 521
FR-A- 2 116 630
US-A- 2 825 042
US-A- 3 904 810

(73) Titulaire: THOMSON-CSF, 51, Esplanade du Général de Gaulle, F-92800 Puteaux(FR)

(72) Inventeur: Lellde, Jean-Yves, THOMSON-CSF
SCPI 19, avenue de Messine, F-75008 Paris(FR)

(74) Mandataire: Courtellemont, Alain et al, THOMSON-CSF
SCPI, F-92045 PARIS LA DEFENSE CEDEX 67(FR)

## Description

La présente invention se rapporte à un joint électrique, élastique destiné à assurer un contact élastique entre deux parois conductrices indépendantes, prévues pour être placées au moins sensiblement orthogonalement l'une par rapport à l'autre.

Il est nécessaire d'utiliser cette sorte de joint pour, par exemple, assurer l'étanchéité électromagnétique entre un boîtier et son couvercle ou pour assurer un contact électrique élastique entre une plaquette de circuit imprimé et une paroi.

De tels joints sont connus qui se présentent sous la forme de bandes métalliques, avec une zone de contact élastique et une zone de fixation par soudure, vissage, procédé autocollant.... voir par ex. US-A 2 825 042 et DE-B 1 190 521. Ces joints connus sont généralement chers, nécessitent des opérations plus ou moins longues pour leur mise en place, sont souvent mal adaptés à mettre en contact des surfaces perpendiculaires, ayant été étudiés, pour la plupart, pour mettre en contact des surfaces parallèles. Souvent ces joints connus présentent une dissymétrie par rapport à la zone de contact, ce qui peut entraîner un couplage électrique spécialement néfaste dans le cas où l'étanchéité électromagnétique est recherchée. Ils sont utilisables pour des tôles mais pas toujours pour des circuits imprimés car, lorsqu'ils sont prévus pour venir en contact avec la tranche d'une paroi, il faut que cette tranche soit conductrice, ce qui n'est généralement pas le cas avec les circuits imprimés.

D'autres joints connus, plus proches des joints selon l'invention, sont formés de bandes métalliques souples pliées pour présenter une section transversale en W. Une partie en V renversée est mise à cheval sur la tranche de la première paroi et les extrémités du W viennent en contact avec la seconde paroi. Lorsque la seconde paroi n'est pas accolée à la première le joint tient mal et risque de tomber, de se perdre ou de s'abimer.

La présente invention a pour but d'éviter ou, pour le moins, de réduire les inconvénients précités.

Ceci est obtenu à l'aide d'une bande métallique souple, découpée en languettes latérales dont certaines sont pliées de manière à former une pince à disposer à cheval sur la première paroi et dont les autres sont pliées pour assurer le contact avec la seconde paroi.

Selon l'invention, un joint électrique, élastique pour assurer un contact élastique entre deux parois conductrices, indépendantes, destinées à être placées au moins sensiblement orthogonalement l'une par rapport à l'autre, est caractérisé en ce qu'il comporte un ruban central métallique et des languettes transversales métalliques réparties de part et d'autre du ruban dont elles sont solidaires, ces languettes formant, pour partie, des premiers contacts galbés, situés au voisinage du plan du ruban et, pour partie, des seconds contacts galbés, pliés par rapport au ruban, sensiblement à + ou - 90° selon le côté du ruban où ils se trouvent, ces seconds contacts constituant les mors d'une pince à mors multiples dont le plan de pincement est orthogonal au plan du ruban.

La présente invention sera mieux comprise et d'autres caractéristiques apparaîtront à l'aide de la description ci-après et des figures s'y rapportant qui représentent :

- la figure 1 une bande métallique utilisée pour la fabrication de joints selon l'invention,
- la figure 2, un joint selon l'invention, en cours de fabrication à partir de la bande selon la figure 1,
- les figures 3 et 4, un joint selon l'invention vu de dessus et vu en bout,
- la figure 5, une vue en coupe montrant un joint selon l'invention, monté entre deux parois perpendiculaires.

Sur les différentes figures les éléments correspondants sont désignés par les mêmes repères, et toutes les figures sont dessinées à l'échelle × 5 par rapport aux indications chiffrées données ci-après pour un exemple de réalisation de l'invention.

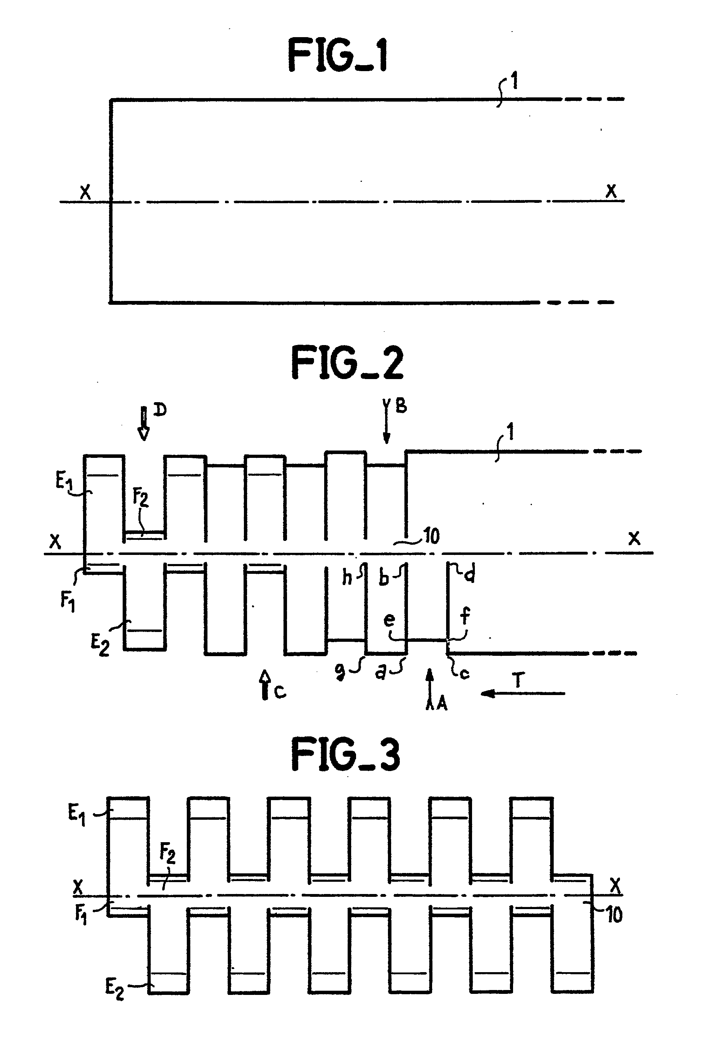

La figure 1 représente une bande métallique souple, 1, de 10 mm de largeur et 0,075 mm d'épaisseur, en bronze au beryllium pré-revenu et étamé ; l'axe longitudinal ou axe médian, XX, de cette bande, a été représenté sur la figure 1.

La figure 2 montre comment, à partir de la bande métallique, 1, est fabriqué un joint selon l'invention, à l'aide d'une machine-outil équipée de deux systèmes de couteaux et de deux systèmes d'emboutissage.

Un dispositif d'entraînement fait avancer la bande pas à pas, de la droite vers la gauche, parallèlement à l'axe XX de la bande. Les pas, symbolisés par un vecteur T, sont tous de 4 mm et, entre deux pas consécutifs, la bande s'arrête le temps d'effectuer quatre opérations simultanées grâce aux systèmes de couteaux et aux systèmes d'emboutissage. En effet, en avançant de la droite vers la gauche, selon l'axe XX, chaque tranche de la bande 1 rencontre successivement : à gauche un des systèmes de couteaux, dont la position sur la figure 2 est repérée par une flèche A - puis, un demi pas plus loin mais sur la droite, l'autre système de couteaux, dont la position est donnée par une flèche B - à nouveau sur la gauche mais un pas et demi plus loin, un des systèmes d'emboutissage, dont la position est repérée par une flèche C - et un pas et demi plus loin, sur la droite, l'autre système d'emboutissage, dont la position est donnée par une flèche D sur la figure 2.

Chaque système de couteaux comporte trois couteaux qui effectuent une découpe en forme de H : deux couteaux découpent selon deux traits perpendiculaires à l'axe XX, allant du bord de la bande jusqu'à 0,5 mm de l'axe XX, le troisième couteau découpe selon un trait limité par le trait des deux autres couteaux et situé à 4,3 mm de l'axe XX. La dernière découpe en H est notée abcdef sur la figure 2 ; elle détermine une languette transversale befd, dont l'extrémité, ef, se trouve à 4,3 mm de l'axe XX, tandis que deux découpes successives, effectuées d'un même côté de la bande 1, déterminent entre elles une languette transversale, telle que abgh, dont l'extrémité, ag, se trouve à 5 mm de l'axe XX. Ces languettes sont toutes de même largeur dans l'exemple décrit.

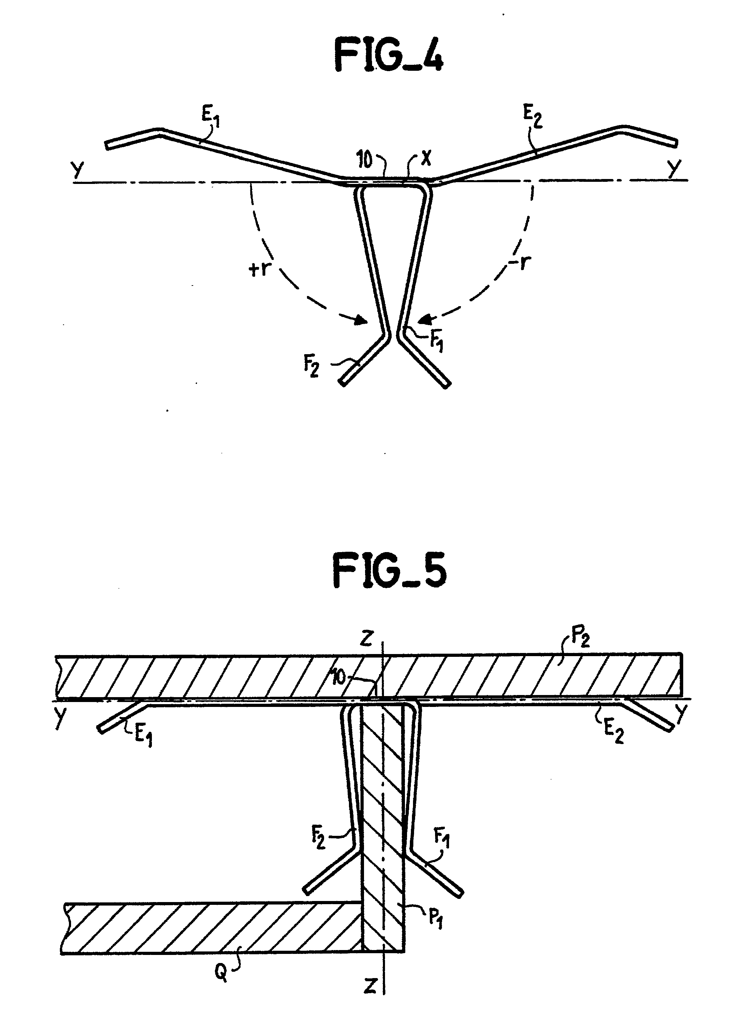

Les systèmes d'emboutissage réalisent un pliage des languettes pour former, avec les languettes les plus longues, des sortes d'ailes, telles que E1, E2, et avec les languettes les plus courtes des sortes de pattes, telles que F1, F2 ; ces ailes et ces pattes, qui se répartissent donc à droite et à gauche d'un ruban central, 10, de 1mm de large, seront décrites plus en détails à l'aide des figures 4 et 5.

Les figures 3 et 4 sont des vues d'un morceau de joint de 2,4 cm, réalisé selon le procédé exposé à l'aide de la figure 2 ; la figure 3 montre le joint vu de dessus et la figure 4 le montre vu en bout. Comme il apparaît sur ces figures, les languettes les plus longues, E1, E2, pliées pour former des sortes d'ailes, sont légèrement amenées vers le haut et galbées mais restent au voisinage du plan du ruban 10 dont il a été question à l'occasion de la description des figures 1 et 2 ; ce plan, perpendiculaire au plan de la figure 4, a été représenté par sa trace, YY, dans le plan de la figure 4 et le point X, où l'axe XX des figures 1, 2, et 3 est perpendiculaire au plan de la figure 4, a été repéré par la lettre X sur la figure 4. Quant aux languettes les plus courtes, F1, F2, qui forment des sortes de pattes, F1, F2, elles sont obtenues en galbant la languette et en lui faisant subir, autour de sa base, une rotation qui l'amène dans une position où elle fait un angle + r ou - r avec le plan du ruban 10 (plan de trace YY sur la figure 4), le signe + ou - étant fonction du côté de l'axe XX où se trouve la languette considérée et la valeur de r étant sensiblement de 90°.

La figure 5 montre comment est utilisé le joint décrit à l'aide des figures 1 à 4, pour assurer un contact entre la tranche d'une première paroi P1 solidaire d'un support Q et une surface d'une seconde paroi, P2, orthogonale à la première. Les languettes les plus courtes, en forme de pattes, telles que F1, F2, constituent les mors d'une pince à mors multiples dont le plan de préhension, de trace ZZ, coupe le plan de la bande métallique d'origine, de trace YY, selon l'axe médian, de trace X, de la bande d'origine ; ainsi ces languettes courtes placées à cheval sur la tranche de la paroi P1 ont un double rôle : par pincement elles assurent à la fois le maintien du joint sur cette paroi et le contact électrique joint-paroi P1. Les languettes les plus longues, en forme d'ailes, telles que E1, E2, plient vers le bas lorsque la paroi P2 est approchée de la tranche de la paroi P1 ; ces languettes assurent alors un bon contact électrique avec la paroi P2.

Il est à noter que le joint qui vient d'être décrit est polyvalent dans la mesure où sa forme et son élasticité lui permettent d'être placé sur la tranche de parois dont l'épaisseur peut être de 0,4 à 0,8 mm.

La présente invention n'est pas limitée à l'exemple décrit, c'est ainsi, en particulier, que dans certaines applications une rangée "d'ailes" peut être supprimée et que des joints peuvent être produits pour des parois dont l'épaisseur peut être supérieure à 0,8 mm ou inférieure à 0,4 mm.

Par ailleurs il est à remarquer que si, dans l'exemple décrit, la longueur des pattes a été réduite par une découpe telle que ef (figure 2), c'est dans le but d'éviter que les pattes viennent en contact avec le support Q (figure 5) ; dans le cas où le joint peut s'enfoncer suffisamment de part et d'autre de la tranche de la paroi, les languettes des ailes et des pattes peuvent être découpées à la même longueur c'est-à-dire que la bande 1 (figure 1) ne nécessite plus de découpe du type ef (figure 2).

Pour ce qui est de la répartition des languettes de part et d'autre du ruban central elle peut être réalisée de diverses façons sans sortir du cadre de l'invention, c'est ainsi, en particulier, qu'il peut être intéressant d'avoir deux "ailes" pour une "patte" ou alternativement deux "ailes"-deux "pattes" au lieu de une "aile" pour une "patte" comme dans l'exemple décrit. De même la largeur des "ailes" peut être différente de celle des "pattes".

Il est également à noter qu'il est possible d'utiliser des bandes en métal mou, susceptibles d'être rendues élastiques par traitement de revenu ; cela facilite la découpe et le cambrage des ailes et des pattes mais nécessite donc, ensuite, un traitement de revenu.

## Revendications

1. Joint électrique, élastique pour assurer un contact élastique entre deux parois (P1, P2) conductrices, indépendantes, destinées à être placées au moins sensiblement orthogonalement l'une par rapport à l'autre, caractérisé en ce qu'il comporte un ruban central métallique (10) et des languettes transversales métalliques (E1, F1, E2, F2) réparties de part et d'autre du ruban dont elles sont solidaires, ces languettes formant, pour partie, des premiers contacts galbés (E1, E2), situés au voisinage du plan du ruban (10) et, pour partie, des seconds contacts galbés (F1, F2), pliés par rapport au ruban, sensiblement à + ou - 90° selon le côté du ruban où ils se trouvent, ces seconds contacts constituant les mors d'une pince à mors multiples dont le plan de pincement (ZZ) est orthogonal au plan du ruban (YY).

2. Joint selon la revendication 1, caractérisé en ce que toutes les languettes (E1, F1, E2, F2) sont de même largeur, et en ce que, de chaque côté du ruban (10), les languettes (E1, E2) formant les premiers contacts sont mélangées avec les languettes (F1, F2) formant les seconds contacts selon une alternance régulière.

3. Joint selon la revendication 2, caractérisé en ce que l'alternance est une alternance une-une et en ce qu'une des languettes (E1, E2) formant premier contact et une des languettes (F1, F2) formant second contact se trouvent toujours en regard de part et d'autre du ruban (10).

## Claims

1. A resilient electrical member for ensuring a resilient contact between two separate conductive walls (P1, P2), intended to be placed in at least substantially orthogonal relation to one another, characterized in that the member comprises a central metal band (10) and metallic transversal tongues (E1, F1, E2, F2) integral with said band and distributed along both sides of it, one part of said tongues forming first cambered contacts (E1, E2) located close to the plane of the band (10), and another part of the tongues forming second cambered contacts (F1, F2), which are bent relative to the band at an angle of substantially + or - 90° depending upon the side of the band to which they are assigned, said second contacts constituting the jaws of multi-jaw tongs, whose clamping plane (ZZ) is disposed perpendicularly to the plane of the band (YY).

2. A contact member according to claim 1, characterized in that all of the tongues (E1, F1, E2, F2) have the same width, and that on each side of the band (10), the tongues (E1, E2) forming the first contacts are mixed up in regular alternation with the tongues (F1, F2) forming the second contacts.

3. A contact member according to claim 2, characterized in that the alternation is a one-by-one alternation, and that one of the tongues (E1, E2) forming first contact and one of the tongues (F1, F2) forming second contact are arranged opposite each other on both sides of the band (10).

**Patentansprüche**

1. Elastisches elektrisches Kontaktglied zur Herstellung eines elastischen Kontaktes zwischen zwei getrennten leitenden Wänden (P1, P2), die zumindest im wesentlichen senkrecht zueinander angeordnet werden sollen, dadurch gekennzeichnet, daß es ein zentrales metallisches Band 10 und metallische Querzungen (E1, F1, E2, F2) aufweist, die Bestandteile des Bandes und zu beiden Seiten desselben verteilt angeordnet sind, wobei ein Teil dieser Zungen erste geschweifte Kontakte (E1, E2) bildet, die sich in der Nähe der Ebene des Bandes (10) befinden, und ein anderer Teil zweite geschweifte Kontakte (F1, F2) bildet, die in Bezug auf das Band im wesentlichen um + oder - 90°, entsprechend der Bandseite, an der sie sich befinden, umgebogen sind, wobei die zweiten Kontakte die Klemmbacken einer Vielfachklemmbackenzange bilden, deren Klemmebene (ZZ) senkrecht zur Bandebene (YY) steht.

2. Kontaktglied nach Anspruch 1, dadurch gekennzeichnet, daß alle Zungen (E1, F1, E2, F2) die gleiche Breite besitzen und daß sich auf jeder Seite des Bandes (10) in regelmäßigem Wechsel die die ersten Kontakte bildenden Zungen (E1, E2) mit den die zweiten Kontakte (F1, F2) bildenden Zungen mischen.

3. Kontaktglied nach Anspruch 2, dadurch gekennzeichnet, daß der Wechsel ein Eins-auf-Eins-Wechsel ist, und daß immer eine der Zungen (E1, E2), die den ersten Kontakt bilden, und eine der Zungen (F1, F2), die den zweiten Kontakt bilden, auf beiden Seiten einander gegenüberstehen.

# FIG_1

# FIG_2

# FIG_3

# FIG_4

# FIG_5